# EUROPÄISCHE PATENTSCHRIFT

(11) **EP 1 480 778 B1**
(45) Veröffentlichungstag und Bekanntmachung des Hinweises auf die Patenterteilung: **12.10.2005**
(21) Anmeldenummer: 03709641.9
(22) Anmeldetag: 24.02.2003
(51) Int. Cl.: B23K 26/06, B23K 26/38, H05K 3/00, B23Q 41/02, B23Q 41/06, B23Q 7/14

(54) **BETRIEBSVERFAHREN FÜR EINE LASERBEARBEITUNGSANLAGE**
OPERATING METHOD FOR A LASER MACHINING SYSTEM
PROCEDE D'UTILISATION D'UN DISPOSITIF DE TRAITEMENT LASER

(30) Priorität: 07.03.2002 DE 10210040
(43) Veröffentlichungstag der Anmeldung: 01.12.2004
(73) Patentinhaber: SIEMENS AKTIENGESELLSCHAFT, 80333 München (DE)
(72) Erfinder: Dietrich, Stefan, 76149 Karlsruhe (DE); Schuchart, Johannes, Sec. 7, Shin Lin District 111, Taipei (TW)
(86) Internationale Anmeldenummer: PCT/DE2003/000577
(87) Internationale Veröffentlichungsnummer: WO 2003/074222

(56) Entgegenhaltungen:
- EP-A- 0 560 204
- EP-A- 0 610 658
- DE-A- 3 525 656
- FR-A- 2 526 700
- GB-A- 2 175 737
- US-A- 5 847 960
- PATENT ABSTRACTS OF JAPAN vol. 014, no. 026 (M-921), 18. Januar 1990 (1990-01-18) & JP 01 266983 A (HITACHI SEIKO LTD), 24. Oktober 1989 (1989-10-24)

## Beschreibung

Die Erfindung betrifft ein Betriebsverfahren für eine Anlage zum Bearbeiten von Objekten mittels Laserstrahlen, insbesondere für eine Anlage zum Bohren bzw. Strukturieren von Leiterplatten und/oder elektronischen Bauelementen gemäß dem Oberbegriff des Anspruchs 1 siehe, z.B., US-A-5 847 960).

Die Materialbearbeitung mittels Laserstrahlen hat durch die rasante Entwicklung der Lasertechnologie in den letzten Jahren zunehmend an Bedeutung gewonnen. Insbesondere auf dem Gebiet der Elektronikfertigung ist durch die zunehmende Miniaturisierung der Bauelemente eine Laserbearbeitung von Leiterplatten bzw. Substraten sowie von elektronischen Bauteilen zu einem unverzichtbaren Werkzeug geworden, um die aufgrund der Miniaturisierung der Bauelemente erforderliche Mikrostrukturierung von Bauelementen und Substraten zu ermöglichen. So können beispielsweise Löcher in Substrate gebohrt werden, welche einen Durchmesser aufweisen, der im Vergleich zu den Lochdurchmessern von mit herkömmlichen Bohrern gebohrten Löchern wesentlich kleiner ist. Unter der Voraussetzung, dass die Laserleistung des auf das Substrat treffenden Laserstrahls genau bekannt ist, können außer Durchgangslöchern auch sogenannte Sacklöcher gebohrt werden, die insbesondere für mehrschichtige Leiterplatten wichtig sind, bei denen mehrere metallische Schichten durch dielektrische Zwischenschichten elektrisch nichtleitend voneinander getrennt sind. Durch eine nachfolgende Metallisierung eines Sackloches können verschiedene metallische Schichten der mehrschichtigen Leiterplatte elektrisch leitend miteinander verbunden werden, so dass die Integrationsdichte auf einem derartigen mehrschichtigen Substrat im Vergleich zu ein- oder zweischichtigen Substraten deutlich erhöht werden kann.

Das Laserbohren von mehrschichtigen Substraten erfolgt üblicherweise mittels zweier unterschiedlicher Prozessschritte. In dem eine Prozessschritt werden die metallischen Schichten, welche üblicherweise Kupfer oder eine Kupferlegierung enthalten, mittels eines Laserstrahls im ultravioletten Spektralbereich lokal abgetragen. In dem anderen Prozessschritt wird eine dielektrische Zwischenschicht mittels eines infraroten Laserstrahls lokal abgetragen, welcher üblicherweise von einem CO₂-Laser erzeugt wird. Aus diesem Grund werden zum Bohren von mehrschichtigen Substraten sog. UV-Laserbearbeitungsmaschinen mit einer im ultravioletten Spektralbereich emittierenden Laserlichtquelle und sog. IR-Laserbearbeitungsmaschinen mit einer im infraroten Spektralbereich emittierenden Laserlichtquelle verwendet. Wenn die IR-Laserbearbeitungsmaschinen zur Erzeugung des IR-Laserstrahls einen CO₂-Laser verwenden, werden diese auch als CO₂-Laserbearbeitungsmaschinen bezeichnet.

Aus der US 5847960 ist eine sog. Kombinations-Laserbearbeitungsmaschine bekannt, welche sowohl einen im ultravioletten Spektralbereich emittierenden Laser als auch einen im infraroten Spektralbereich emittierenden Laser enthält. Kombinations-Laserbearbeitungsmaschinen haben den Nachteil, dass die Bearbeitungsgeschwindigkeit durch den im ultravioletten Spektralbereich emittierenden Laser erheblich kleiner als die Bearbeitungsgeschwindigkeit durch den im infraroten Spektralbereich emittierenden Laser ist. Deshalb ist die Auslastung der Kombinations-Laserbearbeitungsmaschine in der Regel schlecht. Aus diesem Grund haben sich zum Bearbeiten von mehrschichtigen Leiterplatten getrennte Laserbearbeitungsmaschinen durchgesetzt.

Der Erfindung liegt die Aufgabe zugrunde, ein Betriebsverfahren zum Bearbeiten von Substraten und elektronischen Bauteilen zu schaffen, welches eine hohe Auslastung der verwendeten unterschiedlich schnell arbeitenden Laserbearbeitungsmaschinen gewährleistet.
Diese Aufgabe wird gelöst durch ein Betriebsverfahren für eine Anlage zum Bearbeiten von Objekten mittels Laserstrahlen mit den Merkmalen des unabhängigen Anspruchs 1.

Der Erfindung liegt die Erkenntnis zugrunde, dass bei dem Einsatz von mehreren Laserbearbeitungsmaschinen, welche voneinander unterschiedliche Bearbeitungsgeschwindigkeiten aufweisen, die Auslastung einer Laserbearbeitungsanlage dadurch erhöht werden kann, dass im Vergleich zu der Anzahl an eingesetzten sog. schnell arbeitenden Laserbearbeitungsmaschinen eine größere Anzahl an sog. langsam arbeitenden Laserbearbeitungsmaschinen eingesetzt wird. Durch den parallelen Betrieb von mehreren langsam arbeitenden Laserbearbeitungsmaschinen wird erreicht, dass innerhalb einer bestimmten Zeitspanne gleich viele oder zumindest annähernd gleich viele Objekte mit beiden Arten von Laserbearbeitungsmaschinen bearbeitet werden können. Die Erhöhung der Auslastung einer Laserbearbeitungsanlage hat den Vorteil, dass für eine bestimmte geforderte Bearbeitungskapazität insgesamt weniger Laserbearbeitungsmaschinen erforderlich sind und somit sowohl die von einer derartigen Anlage beanspruchte Stellfläche als auch die Betriebskosten der Laserbearbeitungsanlage erheblich reduziert werden können.

Gemäß Anspruch 2 werden die Objekte mittels eines Transportsystems zugeführt, welches beispielsweise als Transport- oder als Förderband ausgebildet sein kann, so dass die Objekte quasi kontinuierlich zugeführt werden.

Gemäß Anspruch 3 werden die Objekte nicht kontinuierlich, sondern mit einer bestimmten Stückzahl diskret sowohl an eine Beladestation der entsprechenden Laserbearbeitungsmaschine zugeführt als auch von einer Endladestation der jeweiligen Laserbearbeitungsmaschine abgeführt. Der diskrete Transport der Objekte hat den Vorteil, dass auf aufwendige Transport- bzw. Förderbänder verzichtet werden kann und der Transport der Objekte auf einfache Weise und damit kostengünstig manuell durchgeführt werden kann.

Gemäß Anspruch 4 werden als Transportsystem zumindest zwei Transportwägen verwendet, welche bevorzugt in die jeweiligen Beladestation bzw. Entladestation eingeschoben werden können, so dass die zu bearbeitenden Objekte direkt von dem einen in der Beladestation befindlichen Transportwagen der Laserbearbeitung zugeführt und nach der Bearbeitung direkt in den anderen in der Entladestation befindlichen Transportwagen abgelegt werden können.

Die Weiterbildung gemäß Anspruch 5 wird bevorzugt durch die Verwendung eines CO₂-Lasers realisiert.

Die Weiterbildung gemäß Anspruch 6 wird bevorzugt mittels eines frequenzvervielfachten Nd:YAG-, Nd:YVO₄- oder ArgonIonen-Lasers realisiert.

Gemäß Anspruch 7 werden mehrschichtige, aus elektrisch isolierenden dielektrischen Schichten und elektrisch leitenden metallischen Schichten aufgebaute Objekte bearbeitet, so dass Leiterplatten bzw. Substrate erzeugt werden können, mittels welchen eine hohe Integrationsdichte an elektronischen Bauelementen erreicht werden kann.

Gemäß Anspruch 8 werden in die zu bearbeitenden Objekte Löcher gebohrt. Je nach Anforderung können die gebohrten Löcher sowohl Durchgangslöcher als auch sog. Sacklöcher sein.

Weitere Vorteile und Merkmale der vorliegenden Erfindung ergeben sich aus der folgenden beispielhaften Beschreibung einer derzeit bevorzugten Ausführungsform.

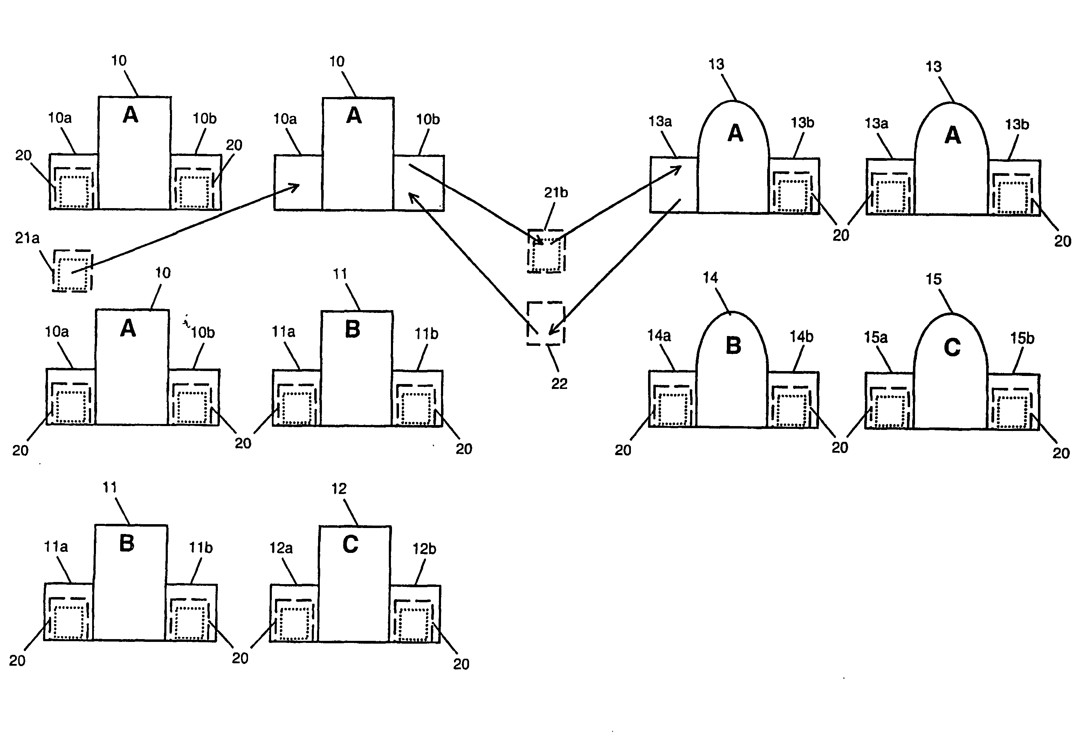

Die einzige Figur zeigt in einer schematischen Darstellung den Aufbau und den logistischen Ablauf einer Laserbearbeitungsanlage, welche unterschiedlich schnell arbeitende Laserbearbeitungsmaschinen aufweist und mittels welcher drei verschiedenartige Objekte A, B, C bearbeitet werden.

Wie aus der Figur ersichtlich, weist die verwendete Laserbearbeitungsanlage zum Bohren von Löchern in mehrschichtigen Leiterplatten insgesamt sechs UV-Laserbearbeitungsmaschinen 10, 11, 12 auf. Von den sechs UV-Laserbearbeitungsmaschinen werden drei UV-Laserbearbeitungsmaschinen 10 zur Bearbeitung eines Leiterplattentyps A verwendet. Zwei UV-Laserbearbeitungsmaschinen 11 werden für die Bearbeitung eines anderen Leiterplattentyps B verwendet. Eine weitere UV-Laserbearbeitungsmaschine 12 wird für die Bearbeitung eines dritten Leiterplattentyps C verwendet. Die Laserbearbeitungsanlage gemäß dem hier dargestellten Ausführungsbeispiel weist ferner vier CO₂-Laserbearbeitungsmaschinen 13, 14, 15 auf, wobei die zwei CO₂-Laserbearbeitungsmaschinen 13 für die Bearbeitung des Leiterplattentyps A, die CO₂-Laserbearbeitungsmaschine 14 für die Bearbeitung des Leiterplattentyps B und die CO₂-Laserbearbeitungsmaschine 15 für die Bearbeitung des Leiterplattentyps C verwendet wird. Jede der insgesamt in der Figur dargestellten zehn Laserbearbeitungsmaschinen weist eine Beladestation 10a, 11a, 12a, 13a, 14a, 15a sowie eine Entladestation 10b, 11b, 12b, 13b, 14b, 15b auf. Die zu bearbeitenden Leiterplatten werden jeweils von den entsprechenden Beladestationen 10a, 11a, 12a, 13a, 14a, 15a mittels einer nicht dargestellten Handhabungsvorrichtung an den Bearbeitungsplatz innerhalb der jeweiligen Laserbearbeitungsmaschine 10, 11, 12, 13, 14, 15 transportiert. Nach der Bearbeitung der entsprechenden Leiterplatte wird diese von dem Bearbeitungsplatz in die entsprechende Entladestation 10b, 11b, 12b, 13b, 14b, 15b transportiert. Der Transport der Leiterplatten zwischen den einzelnen Laserbearbeitungsmaschinen 10, 11, 12, 13, 14, 15 erfolgt mittels eines Transportwagens 20, 21a, 21b, 22, welcher eine Mehrzahl von Leiterplatten aufnehmen kann, die bevorzugt in einen Stapel angeordnet sind. Die Transportwägen 20, 21a, 21b, 22, sind derart ausgebildet, dass sie in die Beladestationen 10a, 11a, 12a, 13a, 14a, 15a bzw. in die Entladestationen 10b, 11b, 12b, 13b, 14b, 15b von jeder der dargestellten Laserbearbeitungsmaschine 10, 11, 12, 13, 14, 15 eingeschoben werden können, so dass während des Betriebes einer Laserbearbeitungsmaschine 10, 11, 12, 13, 14, 15 sowohl in der Beladestation 10a, 11a, 12a, 13a, 14a, 15a als auch in der jeweiligen Entladestation 10b, 11b, 12b, 13b, 14b, 15b ein in der Regel zumindest teilweise mit Leiterplatten beladener Transportwagen 20 vorhanden ist.

Um einen zügigen und unterbrechungsfreien Produktionsablauf zu gewährleisten, können zusätzlich an bestimmten Stellen eine variable Anzahl an zur Zeit nicht verwendeten Transportwägen aufgestellt werden. Eine derartige Vorratshaltung an Transportwägen ist aus Gründen der Platzersparnis insbesondere in der Nähe der drei Beladestationen 10a, 11a der in der Figur links dargestellten drei Laserbearbeitungsmaschinen 10, 11 und in der Nähe der zwei Entladestationen 13b, 15b der zwei in der Figur rechts dargestellten Laserbearbeitungsmaschinen 13, 15 vorteilhaft.

Im folgenden wird der Verlauf der Übergabe von Leiterplatten beispielhaft durch eine Übergabe von der UV-Laserbearbeitungsmaschine 10, welche in der Figur in der zweiten Spalte von links an der oberen Position dargestellt ist, an die CO₂-Laserbearbeitungsmaschine 13 beschrieben, welche in der Figur in der dritten Spalte von links an der oberen Position dargestellt ist. Nachdem mittels der Laserbearbeitungsmaschine 10 eine bestimmte Anzahl an Leiterplatten bearbeitet und in dem in der Entladestation 10b eingeschobenen Transportwagen abgelegt wurde, wird der in der Regel vollständig beladene Transportwagen 21b aus der Entladestation 10b entfernt und in eine Beladestation 13a einer CO₂-Laserbearbeitungsmaschine 13 geschoben, mittels welcher nachfolgend weitere Bearbeitungsschritte an den in dem Transportwagen 21b befindlichen Leiterplatten durchgeführt werden. Gleichzeitig wird (a) ein leerer Transportwagen 22, welcher zuvor in der Beladestation 13a der CO₂-Laserbearbeitungsmaschine 13 eingeschoben war, in den freigewordenen Platz der Entladestation 10b der UV-Laserbearbeitungsmaschine 10 eingeschoben und (b) ein leerer Transportwagen (nicht dargestellt) aus der Beladestation 10a entfernt und durch einen vollen Transportwagen 21a ersetzt. Somit kann die nacheinander erfolgende Bearbeitung einer Vielzahl von Leiterplatten mittels unterschiedlichen Bearbeitungsmaschinen durchgeführt werden, wobei die Bearbeitung von Leiterplatten in keiner der Laserbearbeitungsmaschinen für einen längeren Zeitraum unterbrochen werden muss.

Da die Zeitdauer, welche die CO₂-Laserbearbeitungsmaschine 13 für die Bearbeitung der ihr zugeführten Leiterplatten benötigt, kürzer ist als die Zeitdauer, welche die verschiedenen UV-Laserbearbeitungsmaschinen 10 zur Bearbeitung der gleichen Anzahl an Leiterplatten benötigen, wird nach der vollständigen Bearbeitung der mittels des Transportwagens 21b zugeführten Leiterplatten ein weiterer vollständig beladener Transportwagen in die Beladestation 13a eingeführt, wobei dieser weitere in der Regel vollständig beladene Transportwagen diejenigen Leiterplatten enthält, welche zuvor mittels einer der beiden anderen in der Figur in der linken Spalte dargestellten UV-Laserbearbeitungsmaschinen 10 bearbeitet wurden.

Ein entsprechender Transport und eine entsprechende Zuführung von verschieden mittels langsam arbeitenden Laserbearbeitungsmaschinen bearbeiteten Leiterplatten an eine schnell arbeitende Laserbearbeitungsmaschinen 14 erfolgt gemäß dem hier skizzierten Ausführungsbeispiel auch mit den Leiterplatten vom Typ B.

Da gemäß dem hier beschriebenen Ausführungsbeispiel die Bearbeitungszeit der Leiterplatten vom Typ C auf beiden Arten von Laserbearbeitungsmaschinen ungefähr gleich lang ist, wird zur Bearbeitung der Leiterplatten vom Typ C eine UV-Laserbearbeitungsmaschine 12 und eine CO₂-Laserbearbeitungsmaschine 15 verwendet, so dass jede von der CO₂-Laserbearbeitungsmaschine 15 bearbeitete Leiterplatte zuvor von der UV-Laserbearbeitungsmaschine 12 bearbeitet wurde.

Es wird darauf hingewiesen, dass die Erfindung nicht auf bestimmte Verhältnisse zwischen der Anzahl an langsam arbeitenden Laserbearbeitungsmaschinen 10, 11, 12 und der Anzahl an schnell arbeitenden Laserbearbeitungsmaschinen 13, 14, 15 beschränkt ist. Je nach Bearbeitungszeit der mittels der verschiedenen Laserbearbeitungsmaschinen durchgeführten Bearbeitung kann für eine effiziente Auslastung der gesamten Laserbearbeitungsanlage das Verhältnis zwischen der Anzahl an schnell arbeitenden Laserbearbeitungsmaschinen 13, 14, 15 und der Anzahl ah langsam arbeitenden Laserbearbeitungsmaschinen 10, 11, 12 frei gewählt werden.

Es wird ferner darauf hingewiesen, das gemäß der Erfindung die Reihenfolge der Bearbeitung nicht darauf beschränkt ist, dass die Leiterplatten zuerst mittels der langsam arbeitenden Laserbearbeitungsmaschinen 10, 11, 12 und danach mittels der schnell arbeitenden Laserbearbeitungsmaschinen 13, 14, 15 bearbeitet wird. Die Bearbeitung kann auch zuerst mittels schnell arbeitenden Laserbearbeitungsmaschinen und danach mittels langsam arbeitenden Laserbearbeitungsmaschinen durchgeführt werden. Ebenso können bestimmte Leiterplatten auch eine Bearbeitung erfordern, bei der mehrfach zwischen einer Bearbeitung durch eine langsam arbeitende Laserbearbeitungsmaschine und einer Bearbeitung durch eine schnell arbeitende Laserbearbeitungsmaschine abgewechselt wird.

Zusammenfassend schafft die Erfindung ein Betriebsverfahren für eine Anlage zum Bearbeiten von Objekten mittels Laserstrahlen, insbesondere für eine Anlage zum Bohren bzw. Strukturieren von Substraten, wobei die Anlage eine größere Anzahl an langsam arbeitenden Laserbearbeitungsmaschinen 10, 11 als an schnell arbeitenden Laserbearbeitungsmaschinen 13, 14 aufweist. Durch den parallelen Betrieb von mehreren langsam arbeitenden Laserbearbeitungsmaschinen 10, 11 kann eine nachfolgend oder zuvor eingesetzte schnell arbeitende Laserbearbeitungsmaschine 13, 14 besser ausgelastet werden. Die Übergabe von zu bearbeitenden bzw. bereits bearbeiteten Objekten erfolgt bevorzugt mittels Transportwägen 20, welche sowohl mit den Beladestationen 10a, 11a, 12a, 13a, 14a, 15a als auch mit den Entladestationen 10b, 11b, 12b, 13b, 14b, 15b der Laserbearbeitungsmaschinen 10, 11, 12, 13, 14, 15 kompatibel sind. Auf diese Weise können die zu bearbeitenden Objekte direkt von einem in einer Beladestation 10a, 11a, 12a, 13a, 14a, 15a befindlichen Transportwagen 20 aufgenommen und nach der Bearbeitung in einen in einer Entladestation 10b, 11b, 12b, 13b, 14b, 15b einer Laserbearbeitungsmaschine 10, 11, 12, 13, 14, 15 eingeschobenen Transportwagen 20 abgelegt werden.

## Patentansprüche

1. Betriebsverfahren für eine Anlage zum Bearbeiten von Objekten mittels Laserstrahlen, insbesondere für eine Anlage zum Bohren bzw. Strukturieren von mehrschichtigen Leiterplatten und/oder elektronischen Bauteilen, welche Anlage zumindest zwei langsame Laserbearbeitungsmaschinen (10) und zumindest eine schnelle Laserbearbeitungsmaschine (13) aufweist, bei dem
innerhalb einer bestimmten Zeitspanne
• mittels einer ersten langsamen Laserbearbeitungsmaschine (10) eine erste Anzahl von Objekten bearbeitet wird,
• mittels der zweiten langsamen Laserbearbeitungsmaschine (10) eine zweite Anzahl von Objekten bearbeitet wird, und
• mittels der schnellen Laserbearbeitungsmaschine (13) eine weitere Anzahl von Objekten bearbeitet wird, welche sowohl größer als die erste Anzahl als auch größer als die zweite Anzahl ist,
**dadurch** kenngezeichnet, daß die Arbeitsabläufe der drei Laserbearbeitungsmaschinen (10, 13) derart aufeinander abgestimmt sind,
• dass die erste Anzahl von Objekten und die zweite Anzahl von Objekten nach der Bearbeitung mittels der ersten bzw. mittels der zweiten langsamen Laserbearbeitungsmaschine (10) abwechselnd der schnellen Laserbearbeitungsmaschine (13) zur weiteren Bearbeitung zugeführt werden oder
• dass die weitere Anzahl von Objekten nach der Bearbeitung mittels der schnellen Laserbearbeitungsmaschine (13) in zumindest eine erste und eine zweite Teilmenge aufgeteilt wird, wobei die erste Teilmenge der ersten langsamen Laserbearbeitungsmaschine (10) und die zweite Teilmenge der zweiten langsamen Laserbearbeitungsmaschine (10) zur weiteren Bearbeitung zugeführt wird.

2. Betriebsverfahren gemäß Anspruch 1, bei dem die Objekte mittels eines Transportsystems zugeführt werden.

3. Betriebsverfahren gemäß Anspruch 2, bei dem
• die zu bearbeitenden Objekte von einer der jeweiligen Laserbearbeitungsmaschine (10, 11, 12, 13, 14, 15) zugeordneten Beladestation (10a, 11a, 12a, 13a, 14a, 15a) abgeholt und die bereits bearbeiteten Objekte an einer der jeweiligen Laserbearbeitungsmaschine (10, 11, 12, 13, 14, 15) zugeordneten Entladestation (10b, 11b, 12b, 13b, 14b, 15b) abgelegt werden und
• mittels des Transportsystems der jeweiligen Beladestation (10a, 11a, 12a, 13a, 14a, 15a) gleichzeitig eine Mehrzahl von Objekten zugeführt und von der jeweiligen Entladestation (10b, 11b, 12b, 13b, 14b, 15b) gleichzeitig eine Mehrzahl von Objekten abgeführt wird.

4. Betriebsverfahren gemäß Anspruch 3, bei dem als Transportsystem zumindest zwei Transportwägen (20, 21a, 21b, 22) verwendet werden, wobei
• ein erster Transportwagen (20) mit der Beladestation (10a, 11a, 12a) einer in der Anlage vorgeschalteten Laserbearbeitungsmaschine (10, 11, 12) koppelbar ist,
• ein zweiter Transportwagen (20) mit der Entladestation (10b, 11b, 12b) der in der Anlage vorgeschalteten Laserbearbeitungsmaschine (10, 11, 12) koppelbar ist, und
• der zweite Transportwagen außerdem mit der Beladestation (13a, 14a, 15a) einer in der Anlage nachgeschalteten Laserbearbeitungsmaschine (13, 14, 15) koppelbar ist, mittels welcher die zu bearbeiteten Objekte nach der Bearbeitung mittels der vorgeschalteten Laserbearbeitungsmaschine (10, 11, 12) bearbeitet werden.

5. Betriebsverfahren gemäß einem der Ansprüche 1 bis 4, bei dem für die Bearbeitung der Objekte mittels der langsamen Laserbearbeitungsmaschinen (10, 11, 12) Laserstrahlen im mittleren oder fernen infraroten Spektralbereich verwendet werden.

6. Betriebsverfahren gemäß einem der Ansprüche 1 bis 5, bei dem für die Bearbeitung der Objekte mittels der schnellen Laserbearbeitungsmaschine (13, 14, 15) Laserstrahlen im sichtbaren oder im ultravioletten Spektralbereich verwendet werden.

7. Betriebsverfahren gemäß einem der Ansprüche 5 bis 6, bei dem mehrschichtige Objekte bearbeitet werden, wobei mittels der langsamen Laserbearbeitungsmaschinen (10, 11, 12) dielektrische Schichten und mittels der schnellen Laserbearbeitungsmaschine (13, 14, 15) metallische Zwischenschichten abgetragen werden.

8. Betriebsverfahren gemäß einem der Ansprüche 1 bis 7, bei dem Löcher in die zu bearbeitenden Objekte gebohrt werden.

## Claims

1. Operating method for a system for machining objects by means of laser beams, more particularly for a system for drilling or structuring multilayer printed circuit boards and/or electronic components, said system having at least two slow-operating laser machining tools (10) and at least one fast-operating laser machining tool (13),
wherein
within a specific time period
• a first number of objects is machined using a first slow-operating laser machining tool (10),
• a second number of objects is machined using the second slow-operating laser machining tool (10) and
• a further number of objects which is both greater than the first number and greater than the second number is machined using the fast-operating laser machining tool (13),
**characterised in that** the operating sequences of the three laser machining tools (10, 13) are synchronised with one another such that
• the first number of objects and the second number of objects, after machining using the first and using the second slow-operating laser machining tool (10) respectively, are supplied in alternation to the fast-operating laser machining tool (13) for further processing or
• the further number of objects, after machining using the fast-operating laser machining tool (13), is divided into at least a first and a second subset, the first subset being supplied to the first slow-operating laser machining tool (10) and the second subset being supplied to the second slow-operating laser machining tool (10) for further processing.

2. Operating method according to claim 1, wherein the objects are supplied using a transport system.

3. Operating method according to claim 2, wherein
• the objects to be machined are collected from a loading station (10a, 11a, 12a, 13a, 14a, 15a) assigned to the respective laser machining tool (10, 11, 12, 13, 14, 15) and the already machined objects are deposited at an unloading station (10b, 11b, 12b, 13b, 14b, 15b) assigned to the respective laser machining tool (10, 11, 12, 13, 14, 15) and
• at the same time the transport system is used to supply a plurality of objects to the respective loading station (10a, 11a, 12a, 13a, 14a, 15a) and at the same time to remove a plurality of objects from the respective unloading station (10b, 11b, 12b, 13b, 14b, 15b).

4. Operating method according to claim 3, wherein at least two trolleys (20, 21a, 21b, 22) are used as the transport system,
wherein
• a first trolley (20) can be coupled to the loading station (10a, 11a, 12a) of a laser machining tool (10, 11, 12) connected upstream in the system,
• a second trolley (20) can be coupled to the unloading station (10b, 11b, 12b) of the laser machining tool (10, 11, 12) connected upstream in the system, and
• the second trolley can also be coupled to the loading station (13a, 14a, 15a) of a laser machining tool (13, 14, 15) connected downstream in the system, by means of which tool the objects to be machined are machined after the machining operation using the upstream laser machining tool (10, 11, 12).

5. Operating method according to one of the claims 1 to 4, wherein laser beams in the medium or far infrared spectral range are used for the machining of objects using the slow-operating laser machining tools (10, 11, 12).

6. Operating method according to one of the claims 1 to 5, wherein laser beams in the visible or in the ultraviolet spectral range are used for the machining of objects using the fast-operating laser machining tool (13, 14, 15).

7. Operating method according to one of the claims 5 to 6, wherein multilayer objects are machined, dielectric layers being removed using the slow-operating laser machining tools (10, 11, 12) and metal intermediate layers being removed using the fast-operating laser machining tool (13, 14, 15).

8. Operating method according to one of the claims 1 to 7, wherein holes are drilled in the objects to be machined.

## Revendications

1. Procédé pour exploiter une installation pour traiter des objets au moyen de rayons laser, en particulier pour une installation pour percer resp. structurer des plaques de circuits imprimés multi-couches et/ou des composants électroniques, laquelle installation comporte au moins deux machines lentes de traitement au laser (10) et au moins une machine rapide de traitement au laser (13),
dans lequel,
à l'intérieur d'une durée déterminée,
• un premier nombre d'objets est traité au moyen d'une première machine lente de traitement au laser (10),
• un deuxième nombre d'objets est traité au moyen de la deuxième machine lente de traitement au laser (10) et
• un autre nombre d'objets est traité au moyen de la machine rapide de traitement au laser (13), lequel nombre est supérieur non seulement au premier nombre, mais aussi au deuxième nombre,
**caractérisé en ce que** les déroulements du travail des trois machines de traitement au laser (10, 13) sont accordés les uns aux autres de manière telle que
• le premier nombre d'objets et le deuxième nombre d'objets, après le traitement au moyen de la première resp. de la deuxième machine lente de traitement au laser (10), sont amenés en alternance à la machine rapide de traitement au laser (13) pour la suite du traitement ou
• l'autre nombre d'objets, après le traitement au moyen de la machine rapide de traitement au laser (13), est réparti en au moins un premier sous-ensemble et un deuxième sous-ensemble, le premier sous-ensemble étant amené à la première machine lente de traitement au laser (10) et le deuxième sous-ensemble, à la deuxième machine lente de traitement au laser (10) pour la suite du traitement.

2. Procédé d'exploitation selon la revendication 1, dans lequel les objets sont amenés au moyen d'un système de transport.

3. Procédé d'exploitation selon la revendication 2, dans lequel
• les objets à traiter sont récupérés au niveau d'une station de chargement (10a, 11a, 12a, 13a, 14a, 15a) affectée à la machine respective de traitement au laser (10, 11, 12, 13, 14, 15) et les objets déjà traités sont déposés au niveau d'une station de déchargement (10b, 11b, 12b, 13b, 14b, 15b) affectée à la machine respective de traitement au laser (10, 11, 12, 13, 14, 15) et
• au moyen du système de transport, une pluralité d'objets est amenée en même temps à la station de chargement respective (10a, 11a, 12a, 13a, 14a, 15a) et une pluralité d'objets est emmenée en même temps à partir de la station de déchargement respective (10b, 11b, 12b, 13b, 14b, 15b).

4. Procédé d'exploitation selon la revendication 3, dans lequel on utilise, en tant que système de transport, au moins deux chariots transporteurs (20, 21a, 21b, 22),
• un premier chariot transporteur (20) pouvant être couplé à la station de chargement (10a, 11a, 12a) d'une machine de traitement au laser (10, 11, 12) placé en amont dans l'installation,
• un deuxième chariot transporteur (20) pouvant être couplé à la station de déchargement (10b, 11b, 12b) de la machine de traitement au laser (10, 11, 12) placée en amont dans l'installation et
• le deuxième chariot transporteur pouvant en outre être couplé à la station de chargement (13a, 14a, 15a) d'une machine de traitement au laser (13, 14, 15) placée en aval dans l'installation et au moyen de laquelle les objets à traiter sont traités après le traitement au moyen de la machine de traitement au laser (10, 11, 12) placé en amont.

5. Procédé d'exploitation selon l'une des revendications 1 à 4, dans lequel on utilise, pour le traitement des objets au moyen des machines lentes de traitement au laser (10, 11, 12), des rayons laser dans la plage spectrale de l'infrarouge moyen ou lointain.

6. Procédé d'exploitation selon l'une des revendications 1 à 5, dans lequel on utilise, pour le traitement des objets au moyen de la machine rapide de traitement au laser (13, 14, 15), des rayons laser dans la plage spectrale visible ou de l'ultraviolet.

7. Procédé d'exploitation selon l'une des revendications 5 à 6, dans lequel sont traités des objets multi-couches, des couches diélectriques étant enlevées au moyen des machines lentes de traitement au laser (10, 11, 12) et des couches intermédiaires métalliques étant enlevées au moyen de la machine rapide de traitement au laser (13, 14, 15).

8. Procédé d'exploitation selon l'une des revendications 1 à 7, dans lequel on perce des trous dans les objets à traiter.
